# EUROPEAN PATENT APPLICATION

(11) **EP 4 836 206 A1**
(43) Date of publication of application: **04.11.2026**
(21) Application number: 25197399.6
(22) Date of filing: 21.08.2025
(51) Int. Cl.: H01R 13/66, H01R 12/77, H01R 31/06, H01R 24/20

(54) **POWER CABLE**

(30) Priority: 30.04.2025 CN 202510564155
(71) Applicant: ASUSTek Computer Inc., Taipei City 11259 (TW); Shenzhen Linewell Industry Co., Ltd, Shenzhen City, Guangdong (CN)
(72) Inventor: LIN, Zheng Wei, 11259 Taipei City (TW); HUANG, Kuo-Chen, 11259 Taipei City (TW); YANG, Yu-Sheng, 11259 Taipei City (TW); YANG, Chen-Han, 11259 Taipei City (TW); XIONG, Jun, Shenzhen City (CN); WEI, Qi, Shenzhen City (CN); ZOU, Hongguo, Shenzhen City (CN); SU, Rihong, Shenzhen City (CN)
(74) Representative: Hoefer & Partner Patentanwälte mbB

(57) **Abstract**

A power cable (100) including a cable body (1) and a functional module (2) is provided. The cable body (1) includes a wiring plug (11), a power plug (12) and a connecting harness (13). The wiring plug (11) is used to connect to a functional element (A1), and the power plug (12) is used to connect to a power supply interface (A2). The connecting harness (13) is connected between the wiring plug (11) and the power plug (12), and includes a first ribbon cable (131). The first ribbon cable (131) includes a plurality of first conducting wires (1310). The functional module (2) includes a current adjusting element (20) and an insulating element (30). The first conducting wires (1310) of the first ribbon cable (131) are connected in parallel through the current adjusting element (20). The insulating element (30) is coated on an outer side of the current adjusting element (20).

## Description

### BACKGROUND

### Technical Field

The disclosure relates to a cable, and particularly relates to a power cable.

### Description of Related Art

With the rapid development of computer electronic technology, power cables, as key components of electrical connections, are widely used in computer products. However, in the modern power cables, the ribbon cables in the connecting harness are prone to inconsistent elasticity of each terminal under long-term stress, resulting in uneven current in the individual conductors of the ribbon cables, thereby reducing the service life of the power cable and affecting the performance of the functional components connected to the power cable.

### SUMMARY

The power cable provided of the disclosure includes a cable body and a functional module. The cable body includes a wiring plug, a power plug, and a connecting harness. The wiring plug is adapted to connect with a functional element, and the power plug is adapted to connect with a power supply interface. The connecting harness is connected between the wiring plug and the power plug, and includes a first ribbon cable. The first ribbon cable includes a plurality of first conducting wires. The functional module includes a current adjusting element and an insulating element. These first conducting wires of the first ribbon cable are connected in parallel through the current adjusting element. The insulating element covers an outer side of the current adjusting element.

In the power cable of the disclosure, the functional module includes a current adjusting element and an insulating element. On one hand, the plurality of first conducting wires of the first ribbon cable are connected in parallel through the current adjusting element, so that the current adjusting element may uniformly distribute current to each first conducting wire, thereby avoiding problems of severe heating of conductors or connection contacts corresponding to high current pins and impedance differences in power supply circuits caused by current imbalance, which in turn extends the lifespan of the power cable and improves the stability and reliability of the working performance of functional elements connected to the power cable. On the other hand, the insulating element covers the outer side of the current adjusting element, so that the insulating element may effectively isolate current, prevent leakage and reduce insulation loss, and prevent moisture, corrosion and mechanical damage, thereby improving the safety and environmental resistance capability of the power cable, and extending the lifespan of the power cable.

### BRIEF DESCRIPTION OF THE DRAWINGS

FIG. 1A is a structural schematic diagram of a power cable provided by an embodiment of the disclosure.
FIG. 1B is a simple block diagram of the power cable of FIG. 1A.
FIG. 2 is an exploded view of the power cable of FIG. 1A from a first perspective.
FIG. 3 is an enlarged view of the current adjusting element of the power cable of FIG. 2.
FIG. 4 is an exploded view of the power cable of FIG. 1A from a second perspective.
FIG. 5 is a side view of a partial structure of the power cable of FIG. 1A.

### DESCRIPTION OF THE EMBODIMENTS

The power cable provided in the disclosure l is used to connect a power supply interface and a functional element. The functional element includes but not limited to a power consuming device such as a graphics card, a motherboard, a central processing unit, or a SATA interface, which are not limited in the embodiments of the disclosure. The power cable is configured as but not limited to a graphics card power cable, a motherboard power cable, a central processing unit power cable, or a SATA interface power cable. In the disclosure, the graphics card power cable is used for illustration purposes only.

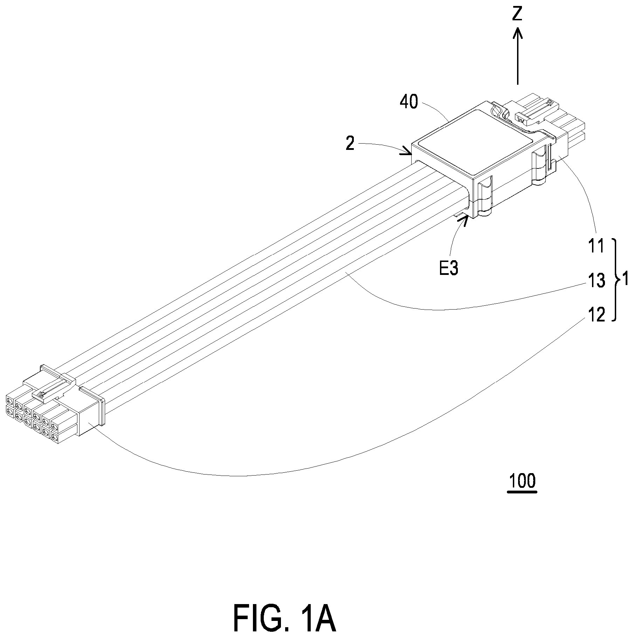

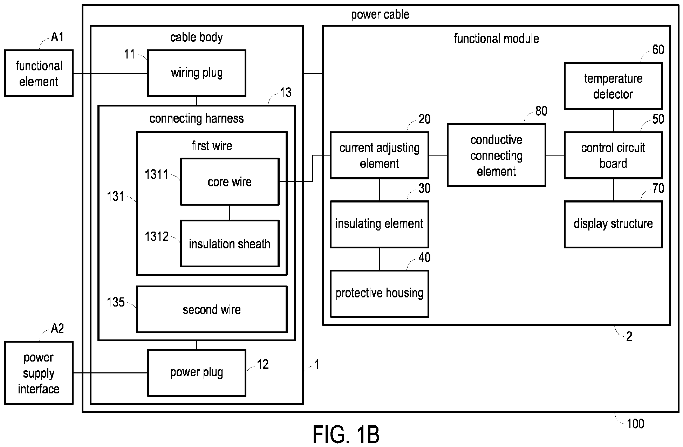

Please refer to FIG. 1A to FIG. 2 together, the power cable 100 includes a cable body 1 and a functional module 2. The cable body 1 includes a wiring plug 11, a power plug 12, and a connecting harness 13. The wiring plug 11 is used to connect with the functional element A1, and the power plug 12 is used to connect with the power supply interface A2. The connecting harness 13 is connected between the wiring plug 11 and the power plug 12, and includes a first ribbon cable 131. The first ribbon cable 131 includes a plurality of first conducting wires 1310. The functional module 2 includes a current adjusting element 20 and an insulating element 30. The plurality of first conducting wires 1310 of the first ribbon cable 131 are connected in parallel through the current adjusting element 20. The insulating element 30 covers an outer side of the current adjusting element 20.

In the power cable 100 provided by the embodiments of the disclosure, the functional module 2 includes the current adjusting element 20 and the insulating element 30, and the plurality of first conducting wires 1310 of the first ribbon cable 131 are connected in parallel through the current adjusting element 20, so that the current adjusting element 20 uniformly distributes current to each first conducting wire 1310, avoiding problems of severe heating of conductors or connection contacts corresponding to high current pins caused by current imbalance and impedance differences in power supply circuits, thereby extending the lifespan of the power cable 100 and improving the stability and reliability of the working performance of functional elements connected to the power cable 100. In addition, the insulating element 30 covers the outer side of the current adjusting element 20 can effectively isolate current, prevent leakage and reduce insulation loss, and prevent moisture, corrosion and mechanical damage, thereby improving the safety and environmental resistance capability of the power cable 100, and extending the lifespan of the power cable 100.

In one embodiment, each first conducting wire 1310 includes a core wire 1311, and the current adjusting element 20 is connected to the core wire 1311. The functional module 2 is disposed at an end portion E1 of the connecting harness 13 close to the wiring plug 11, so as to avoid the problem that the functional module 2 is disposed in the middle or close to the middle position of the connecting harness 13 and thus affects the bending and extending movement of the connecting harness 13. In addition, the functional module 2 is disposed at a position close to the wiring plug 11 may also avoid the problem that the current adjusting element 20 bends under the bending force and reduces the connection reliability with the core wire 1311, improving the uniform distribution effect of the current adjusting element 20 on the current of the first conducting wire 1310.

In one embodiment, a distance between an end of the current adjusting element 20 adjacent to the wiring plug 11 and the wiring plug 11 may be less than or equal to 3 centimeters, and the functional module 2 may be disposed at other positions of the connecting harness 13, which is not limited in the disclosure.

In one embodiment, the plurality of first conducting wires 1310 are arranged at equal intervals. Any two adjacent first conducting wires 1310 are disposed in parallel. Some of the plurality of first conducting wires 1310 may also be arranged at non-equal intervals.

In one embodiment, each first conducting wire 1310 further includes an insulation sheath 1312. The insulation sheath 1312 covers an outer side of the core wire 1311. The insulation sheath 1312 of each first conducting wire 1310 is provided with a notch 1313 exposing the core wire 1311 at the end portion E1 close to the wiring plug 11. The current adjusting element 20 is disposed at the notch 1313 and connected to the core wire 1311, to facilitate assembly of the current adjusting element 20 and the first conducting wire 1310, and avoid the problem that the current adjusting element 20 is disposed at a position close to the center of the first conducting wire 1310 and thus affects the bending and extending movement of the first conducting wire 1310.

In one embodiment, the notch 1313 is annular, and the current adjusting element 20 is disposed at the notch 1313. The notch 1313 may also be arc-shaped, which is not limited in the disclosure.

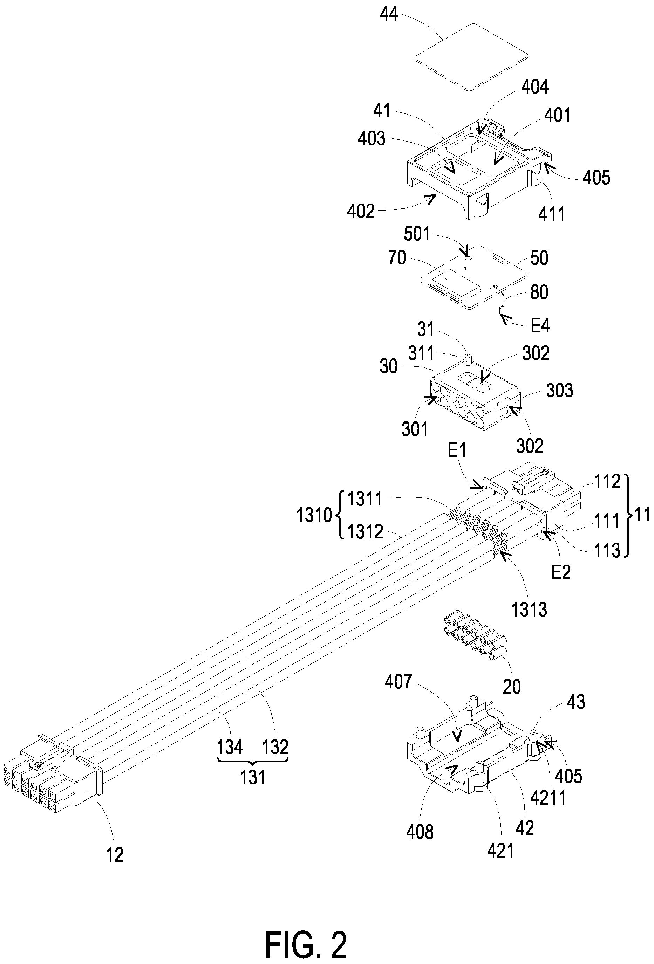

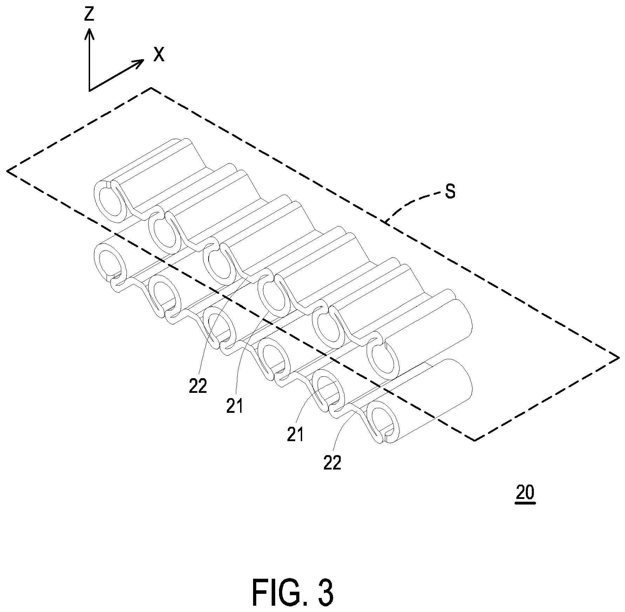

Please refer to FIG. 2 and FIG. 3 together, the current adjusting element 20 includes a plurality of first connecting portions 21 and at least one second connecting portion 22. The second connecting portion 22 is connected between the two adjacent first connecting portions 21. The first connecting portion 21 is configured as a hollow cylindrical structure and is sleeved at the position of the core wire 1311 corresponding to the notch 1313. The second connecting portion 22 is configured as an arched structure or a planar structure. The first connecting portions 21 and the second connecting portions 22 are alternately disposed, so that the second connecting portion 22 may limit the spacing between the two adjacent first conducting wires 1310, thereby making the heat distribution consistent when the plurality of first conducting wires 1310 carry current, preventing a certain first conducting wire 1310 from concentrated heating due to excessively small spacing, and the consistent spacing of the plurality of first conducting wires 1310 arranged in parallel may reduce the mutual inductance effect under high-frequency current, avoid voltage fluctuation caused by electromagnetic interference. The first conducting wires 1310 disposed at equal intervals have uniform stress distribution when bending, avoiding a single first conducting wire 1310 from bearing additional mechanical stress due to spacing compression, and improving installation convenience; the first connecting portion 21 is sleeved at the position of the core wire 1311 corresponding to the notch 1313 to increase the connection area between the current adjusting element 20 and the core wire 1311, improving connection reliability and stability. When the second connecting portion 22 is configured as an arched structure, the second connecting portion 22 may press the first connecting portion 21 against the core wire 1311 along an axial direction X, improving the stability and reliability of the connection between the core wire 1311 and the current adjusting element 20, and facilitating the alignment assembly of the current adjusting element 20 and the insulating element 30. When the second connecting portion 22 is configured as a planar structure, the processing mold of the current adjusting element 20 is simplified, reducing the processing difficulty of the current adjusting element 20.

In one embodiment, the first connecting portion 21 and the second connecting portion 22 are integrally formed, and the current adjusting element 20 is disposed on the core wire 1311 through crimping.

In one embodiment, the current adjusting element 20 has a strip structure before crimping. The strip structure may be configured as a wave-like structure to facilitate the alignment assembly of the plurality of first conducting wires 1310 with the current adjusting element 20. After the current adjusting element 20 is crimped on the core wire 1311 through a crimping tool, the current adjusting element 20 forms a structure where the first connecting portions 21 and the second connecting portions 22 are alternately arranged. In other embodiments, the first connecting portions 21 and the second connecting portions 22 are independently disposed and fixedly connected through welding or crimping, and the current adjusting element 20 may also be disposed on the core wire 1311 through welding or other methods, which is not limited in the disclosure.

In one embodiment, a material of the current adjusting element 20 may be but not limited to copper, copper alloy, aluminum, aluminum alloy, etc. In other embodiments, the first connecting portion 21 may be configured as any polygonal structure. In some embodiments, the first connecting portion 21 and the second connecting portion 22 may be configured as planar structures, meaning that the current adjusting element 20 is a flat metal sheet. The second connecting portion 22 may be disposed on the core wire 1311 through welding. In some embodiments, the current adjusting element 20 may be formed by solder. The liquid or solid solder may be directly welded on the plurality of core wires 1311, and the solidified solder serves as the current adjusting element 20.

In one embodiment, the insulating element 30 is connected to the current adjusting element 20 to form an integral structure, and the insulating element 30 is covered on the outer side of the current adjusting element 20 using injection molding process.

In one embodiment, the insulating element 30 and the current adjusting element 20 are independently disposed and fixedly connected. For example, the insulating element 30 may include two insulators that are engaged and fixed to each other, and the current adjusting element 20 and the plurality of first conducting wires are clamped between the two insulators.

The insulating element 30 is provided with a plurality of threading holes 301 disposed at intervals. The plurality of first conducting wires 1310 respectively pass through the plurality of threading holes 301.

In one embodiment, the length of the insulating element 30 in the axial direction X of the first conducting wire 1310 is greater than or equal to the length of the current adjusting element 20 in the axial direction X of the first conducting wire 1310.

In one embodiment, the number of the first ribbon cables 131 is at least one. The number of the current adjusting elements 20 is at least one. The plurality of first conducting wires 1310 of the at least one first ribbon cable 131 are connected in parallel through the corresponding current adjusting element 20. Thus, the plurality of first conducting wires 1310 with the same signal transmission function may achieve current uniformity through the current adjusting element 20.

In one embodiment, the power cable 100 is the graphics card power cable. The number of the first ribbon cables 131 and the current adjusting elements 20 are each disposed to two, the two current adjusting elements 20 are insulated from each other, and the plurality of first conducting wires 1310 of each first ribbon cable 131 are connected in parallel through the corresponding current adjusting element 20. Thus, the output signals of the plurality of first conducting wires 1310 of the two first ribbon cables 131 do not interfere with each other, improving the accuracy of signal transmission of the power cable 100.

Specifically, the two first ribbon cables 131 include a first sub wire 132 and a second sub wire 134. The first sub wire 132 and the second sub wire 134 are independently disposed. The first sub wire 132 is used for transmitting a first signal, and the second sub wire 134 is used for transmitting a second signal. The first sub wire 132 and the second sub wire 134 each include six first conducting wires 1310. Of course, in some embodiments, the first sub wire 132 and the second sub wire 134 may each include three, four, or more than six first conducting wires 1310, which is not specifically limited in the embodiments of the disclosure. In this embodiment, the notch of the first sub wire 132 and the notch of the second sub wire 134 are aligned in a thickness direction Z of the power cable 100, so that the two current adjusting elements 20 are aligned in the thickness direction Z. Thereby, one insulating element 30 simultaneously covers the two current adjusting elements 20. Of course, in some embodiments, the notch of the first sub wire 132 and the notch of the second sub wire 134 may be misaligned in the thickness direction Z, so that the two current adjusting elements 20 are misaligned in the thickness direction Z. The insulating element 30 may be disposed as two to respectively cover the two current adjusting elements 20.

In one embodiment, a surface parallel to the extending direction of the first ribbon cable 131 is defined as a symmetrical plane S, and the plurality of current adjusting elements 20 are disposed in mirror symmetry with respect to the symmetrical plane S. Thus, it facilitates the alignment and assembly of the insulating element 30 with the current adjusting elements 20, and improves the uniformity of the mechanical performance of the overall structure.

The number of the first ribbon cables 131 and the number of the current adjusting elements 20 may be the same or different, which is not limited in the disclosure.

In one embodiment, the functional module 2 includes a protective housing 40. The insulating element 30 is disposed close to the wiring plug 11 and is spaced apart from the wiring plug 11. The protective housing 40 covers an outer side of the insulating element 30, the protective housing 40 is engaged with an end portion E2 of the wiring plug 11 close to the power plug 12, and the connecting harness 13 passes through an end portion E3 of the protective housing 40 away from the wiring plug 11.

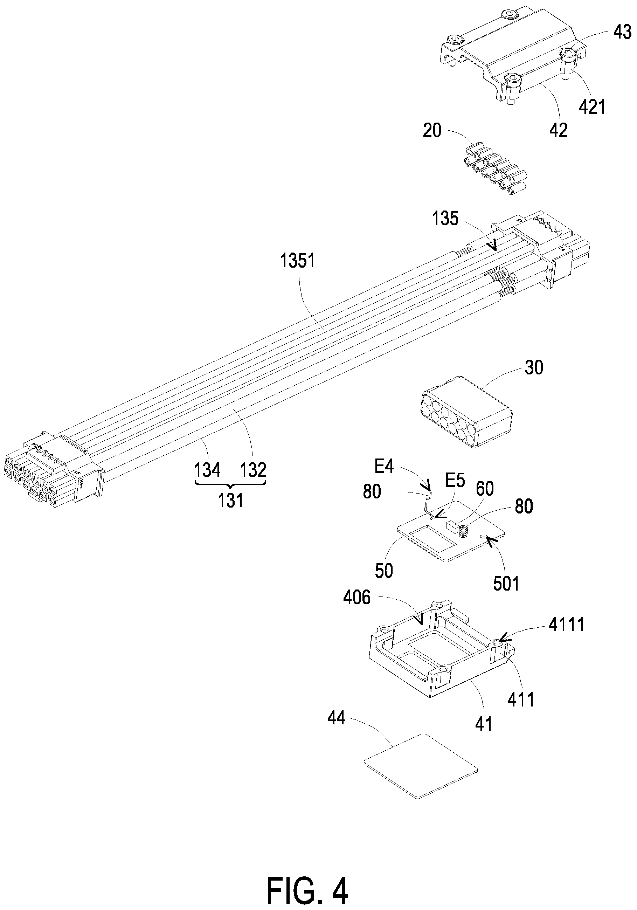

Please refer to FIG. 1A, FIG. 2 and FIG. 4 together, in one embodiment, the functional module 2 includes a control circuit board 50, a temperature detector 60 and at least one display structure 70. The control circuit board 50 is conductively connected to the temperature detector 60, all display structures 70 and the current adjusting elements 20. The temperature detector 60 is used to detect the temperature of the current adjusting elements 20. The control circuit board 50 is used to control the at least one display structure 70 to display a current temperature information of the current adjusting elements 20 detected by the temperature detector 60. Thus, the temperature detector 60 may detect the temperature of the connecting harness 13 in real time, and display the current temperature information through the display structure 70, so as to facilitate users to observe the temperature of the power cable 100 in real time, and to intervene in time when the temperature of the power cable 100 is abnormal, avoiding the problem of the power cable 100 being burned due to temperature runaway and damaging the graphics card. It should be noted that since the current adjusting elements 20 are connected in series with the plurality of core wires 1311 corresponding to the plurality of first conducting wires 1310, the temperature of the current adjusting elements 20 is close to the temperature of the core wires 1311, thereby indirectly measuring the temperature of the first ribbon cable 131.

In one embodiment, the current temperature information includes but not limited to at least one of temperature value and temperature level. The temperature level is characterized by but not limited to at least one of light color, light brightness, light flashing method, and text description. The display structure 70 is a display screen or a light-emitting element, which is not limited in the disclosure. In one embodiment, the number of the display structures 70 is two, wherein one display structure 70 is the display screen and is used to display the temperature value, and wherein the other display structure 70 is the light-emitting element and is used to display the temperature level.

In one embodiment, when the display structure 70 is the light-emitting element, the light-emitting element may emit light of at least one of different colors, brightness and flashing methods to characterize different temperature levels corresponding to the current adjusting elements 20, thereby facilitating users to understand the temperature of the power cable 100.

In one embodiment, the display screen is a touch display screen or a non-touch display screen, which is not limited in the disclosure.

In one embodiment, the functional module 2 includes at least one of or a combination of a speaker, a display screen and a light-emitting element, and the current temperature information may be fed back to the user through sound or voice.

In one embodiment, the protective housing 40 is provided with a storage cavity 401 and a through hole 402 communicated with the storage cavity 401. The connecting harness 13 is partially stored in the storage cavity 401, and an end of the connecting harness 13 away from the wiring plug 11 passes through the through hole 402. The control circuit board 50 and the temperature detector 60 are disposed in the storage cavity 401, the control circuit board 50 and the connecting harness 13 are arranged in the thickness direction Z of the power cable 100, and are conductively connected to the first ribbon cable 131 through the current adjusting element 20.

In one embodiment, the temperature detector 60 and at least one display structure 70 are disposed on the control circuit board 50. The control circuit board 50 is disposed between the insulating element 30 and the protective housing 40.

In one embodiment, the display structure 70 is located on a side of the control circuit board 50 facing away from the connecting harness 13, and is conductively connected to the control circuit board 50.

In one embodiment, the protective housing 40 is provided with at least one mounting hole 403 communicated with the storage cavity 401. The display structure 70 may be installed in the same mounting hole 403 or different mounting holes 403, which is not limited in the disclosure.

In one embodiment, the protective housing 40 includes a first housing 41 and a second housing 42. The first housing 41 and the second housing 42 are engaged and fixed to each other, and cooperatively form the storage cavity 401 and the through hole 402 communicated with the storage cavity 401. The connecting harness 13 passes through the through hole 402. A side of the first housing 41 facing away from the second housing 42 is provided with a mounting hole 403 communicated with the storage cavity 401, and the display structure 70 is installed at the mounting hole 403. The number of the mounting holes 403 may be set according to the number and setup method of the display structures 70, which is not limited in the disclosure.

In one embodiment, the protective housing 40 further includes a locking element 43. The first housing 41 and the second housing 42 are detachably connected through the locking element 43. Specifically, a side wall of the first housing 41 is provided with a plurality of first lugs 411, and a side wall of the second housing 42 is provided with a plurality of second lugs 421. One of the first lug 411 and the second lug 421 is provided with a connecting hole 4211, and the other one of the first lug 411 and the second lug 421 is provided with a fixing hole 4111 aligned with the connecting hole 4211. The locking element 43 passes through the connecting hole 4211 and is locked in the fixing hole 4111. The setup of the first lug 411 and the second lug 421 may enhance the reliability and stability of the connection between the locking element 43 and the first housing 41 and the second housing 42.

In one embodiment, the first housing 41 and the second housing 42 may also be fixedly connected together through magnetic adsorption structure, snap-fit, adhesive bonding, welding, or injection molding structures, which is not limited in the disclosure.

In one embodiment, the protective housing 40 includes a decorative plate 44. The decorative plate 44 is located on a side of the first housing 41 facing away from the second housing 42, and is sealingly connected to the first housing 41. The decorative plate 44 covers the mounting hole 403. The decorative plate 44 and the display structure 70 are independently disposed from each other, and configured as a transparent structure; alternatively, the decorative plate 44 and the display structure 70 are integrated as an integral structure.

In one embodiment, the decorative plate 44 is the transparent structure or a non-transparent structure, which is not limited in the disclosure.

In one embodiment, a side of the first housing 41 facing away from the second housing 42 is provided with a positioning groove 404. The decorative plate 44 is disposed in the positioning groove 404.

In one embodiment, the protective housing 40 is a non-insulating structure, such as a metal structure, to improve the structural strength and heat dissipation performance of the protective housing 40. In another embodiment, the protective housing 40 is provided with a heat dissipation structure for discharging heat generated by the current adjusting element 20 to an external air.

In one embodiment, a side wall 303 of the insulating element 30 is provided with a conductive connecting hole 302. The functional module 2 further includes a conductive connecting element 80. One end E4 of the conductive connecting element 80 passes through the conductive connecting hole 302 and is conductively connected to the current adjusting element 20, and the other end E5 of the conductive connecting element 80 is conductively connected to the control circuit board 50. Thus, the setup of the conductive connecting hole 302 may shorten the connecting circuit between the conductive connecting element 80 and the current adjusting element 20 and the control circuit board 50.

In one embodiment, the number of conductive connecting holes 302 is two, and the two conductive connecting holes 302 are separately disposed. The conductive connecting elements 80 are also disposed as two, and the two conductive connecting elements 80 respectively pass through the two conductive connecting holes 302.

In one embodiment, the number of conductive connecting holes 302 may be the same as or different from the number of conductive connecting elements 80, which is not limited in the disclosure. In one embodiment, the insulating element 30 may not be provided with conductive connecting holes 302, for example, the conductive connecting element 80 may pass through the threading hole 301 to connect with the circuit board.

In one embodiment, the insulating element 30 is provided with a positioning structure 31, and the control circuit board 50 is provided with a guide structure 501 that cooperates with the positioning structure 31. One of the positioning structure 31 and the guide structure 501 is configured as a protruding structure, and one of the positioning structure 31 and the guide structure 501 is configured as a groove structure or positioning hole that cooperates with the protruding structure.

In one embodiment, the positioning structure 31 is provided with a limiting step 311, and the control circuit board 50 is mounted on the limiting step 311. The limiting step 311 avoids the problem of short circuit caused by contact between the control circuit board 50 and the current equalizing plate by lifting the control circuit board 50. The setup of the limiting step 311 may form a heat dissipation channel between the control circuit board 50 and the insulating element 30.

In one embodiment, the temperature detector 60 is disposed on a side of the control circuit board 50 facing the current adjusting element 20 or on a side of the control circuit board 50 facing away from the insulating element 30, which is not limited in the disclosure.

In one embodiment, the first housing 41 is provided with a first limiting groove 406, the second housing 42 is provided with a second limiting groove 407 oppositely disposed to the first limiting groove 406. One end of the insulating element 30 is limited within the first limiting groove 406, and the other end of the insulating element 30 is limited within the second limiting groove 407.

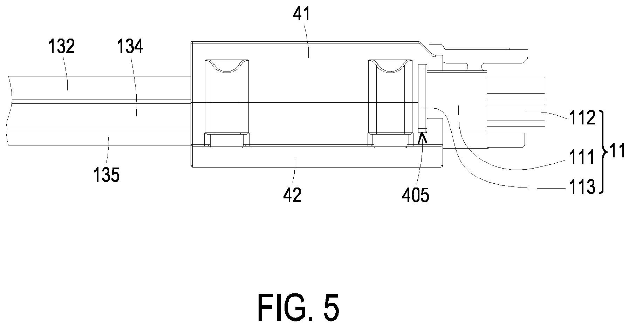

Please refer to FIG.2 and FIG.5 together, in one embodiment, the wiring plug 11 includes a plug body 111 and a terminal 112 disposed on the plug body 111. The plug body 111 is provided with a flange base 113 on a side approaching the insulating element 30. The first housing 41 and the second housing 42 form an engaging slot 405 by surrounding at an end portion close to the wiring plug 11. The engaging slot 405 cooperates with the flange base 113 for fixing.

In one embodiment, the wiring plug 11 may also be locked and fixed between the first housing 41 and the second housing 42 through an additional locking structure, which is not limited in the disclosure.

In one embodiment, the connecting harness 13 includes a second ribbon cable 135. The second ribbon cable 135 includes a plurality of second conducting wires 1351. The second ribbon cable 135 is disposed between the insulating element 30 and the protective housing 40.

In one embodiment, the second ribbon cable 135 and at least one first ribbon cable 131 are arranged in the thickness direction Z of the power cable 100. The second housing 42 is further provided with a storage groove 408 communicated with the second limiting groove 407. A depth of the storage groove 408 is greater than a depth of the second limiting groove 407, and the second ribbon cable 135 is stored within the storage groove 408. Thus, a groove side wall of the storage groove 408 and a groove side wall of the second limiting groove 407 form a step surface, the storage groove 408 is recessed relative to the second limiting groove 407, thereby simultaneously achieving aligned assembly of the insulating element 30 and the second ribbon cable 135.

In one embodiment, the insulating element 30 may also be covered on an outer side of the second ribbon cable 135 by injection molding process; alternatively, the insulating element 30 is provided with threading holes 301 for the second conducting wires 1351 of the second ribbon cable 135 to pass through. Alternatively, the second ribbon cable 135 is disposed to an outer side the storage cavity 401 of the protective housing, which is not specifically limited in the embodiments of the disclosure. In some embodiments, the functional module 2 may only include the current adjusting element 20 and the insulating element 30.

In summary, the power cable of the disclosure, based on the addition of a functional module, the functional module includes a current adjusting element and an insulating element, on one hand, the plurality of first conducting wires of the first ribbon cable are connected in parallel through the current adjusting element, so that the current adjusting element may uniformly distribute current to each first conducting wire, thereby avoiding the problem of severe heating of conductors or connection contacts corresponding to high current pins due to current imbalance and causing impedance differences in the power supply circuit, further extending the lifespan of the power cable and improving the stability and reliability of the working performance of functional elements connected to the power cable. On the other hand, the insulating element covers the outer side of the current adjusting element, so that the insulating element may effectively isolate current, prevent leakage and reduce insulation loss, and prevent moisture, corrosion and mechanical damage, further improving the safety and environmental resistance capability of the power cable, and extending the lifespan of the power cable.

## Claims

1. A power cable (100), comprising:
a cable body (1), comprising a wiring plug (11), a power plug (12) and a connecting harness (13), the wiring plug (11) is adapted to connect with a functional element (A1), the power plug (12) is adapted to connect with a power supply interface (A2), the connecting harness (13) is connected between the wiring plug (11) and the power plug (12), and the connecting harness (13) comprises a first ribbon cable (131), the first ribbon cable (131) comprises a plurality of first conducting wires (1310); and
a functional module (2), comprising:
a current adjusting element (20), the first conducting wires (1310) are connected in parallel through the current adjusting element (20); and
an insulating element (30), covering an outer side of the current adjusting element (20).

2. The power cable (100) as described in claim 1, wherein each of the first conducting wires (1310) comprises a core wire (1311) and an insulation sheath (1312), the insulation sheath (1312) covers an outer side of the core wire (1311), the insulation sheath (1312) of each of the first conducting wires (1310) is provided with a notch (1313) exposing the core wire (1311) at an end portion (E1) close to the wiring plug (11), the current adjusting element (20) is disposed at the notch (1313) and connected to the core wire (1311).

3. The power cable (100) as described in claim 2, wherein the current adjusting element (20) comprises a plurality of first connecting portions (21) and at least one second connecting portion (22), the second connecting portion (22) connected between the two adjacent first connecting portions (21), the first connecting portion (21) is configured as a hollow cylindrical structure and is sleeved at the core wire (1311) exposed at the notch (1313), the second connecting portion (22) is configured as an arched structure or a planar structure.

4. The power cable (100) as described in claim 1, wherein the power cable (100) is a graphics card power wire, a motherboard power wire, a central processing unit power wire or a SATA interface power wire, the number of the first ribbon cables (131) is a plurality of, the number of the current adjusting elements (20) is at least one.

5. The power cable (100) as described in claim 1, wherein the power cable (100) is a graphics card power wire, the number of each of the first ribbon cables (131) and the current adjusting elements (20) is two, the two current adjusting elements (20) are insulated from each other.

6. The power cable (100) as described in claim 1, wherein the functional module (2) further comprises a protective housing (40), the insulating element (30) is disposed close to the wiring plug (11) and is spaced apart from the wiring plug (11), the protective housing (40) covers an outer side of the insulating element (30), the protective housing (40) is engaged with an end portion (E2) of the wiring plug (11) close to the power plug (12), the connecting harness (13) passes through an end portion (E3) of the protective housing (40) away from the wiring plug (11).

7. The power cable (100) as described in claim 6, wherein the functional module (2) further comprises a control circuit board (50), a temperature detector (60) and at least one display structure (70), the control circuit board (50) is conductively connected to the temperature detector (60), the at least one display structure (70) and the current adjusting element (20), the temperature detector (60) is adapted to detect a temperature of the current adjusting element (20), the control circuit board (50) is adapted to control the at least one display structure (70) to display a current temperature information of the current adjusting element (20) detected by the temperature detector (60), wherein the current temperature information comprises at least one of temperature value and temperature level.

8. The power cable (100) as described in claim 7, wherein a side wall of the insulating element (30) is provided with a conductive connecting hole (302), the functional module (2) further comprises a conductive connecting element (80), one end (E4) of the conductive connecting element (80) passes through the conductive connecting hole (302) and conductively connected to the current adjusting element (20), the other end (E5) of the conductive connecting element (80) is conductively connected to the control circuit board (50).

9. The power cable as described in claim 6, wherein the protective housing (40) comprises a first housing (41) and a second housing (42) cooperatively fixed with the first housing (41), the first housing (41) is provided with a first limiting groove (406), the second housing (42) is provided with a second limiting groove (407) oppositely disposed with the first limiting groove (406), in a thickness direction (Z) of the power cable (100), one end of the insulating element (30) is limited within the first limiting groove (406), the other end of the insulating element (30) is limited within the second limiting groove (407).

10. The power cable (100) as described in claim 6, the connecting harness (13) further comprises a second ribbon cable (135), the second ribbon cable (135) comprises a plurality of second conducting wires (1351), the second ribbon cable (135) is disposed between the insulating element (30) and the protective housing (40).

## Amended claims

### Amended claims in accordance with Rule 137(2) EPC.

1. A power cable (100), comprising:
a cable body (1), comprising a wiring plug (11), a power plug (12) and a connecting harness (13), the wiring plug (11) is adapted to connect with a functional element (A1), the power plug (12) is adapted to connect with a power supply interface (A2), the connecting harness (13) is connected between the wiring plug (11) and the power plug (12), and the connecting harness (13) comprises a first ribbon cable (131), the first ribbon cable (131) comprises a plurality of first conducting wires (1310); and
a functional module (2), comprising:
a current adjusting element (20); and
an insulating element (30), covering an outer side of the current adjusting element (20);
**characterized in that** a material of the current adjusting element (20) is metal, the current adjusting element (20) is connected to the first conducting wires (1310), and the first conducting wires (1310) are connected in parallel through the current adjusting element (20).

2. The power cable (100) as described in claim 1, wherein each of the first conducting wires (1310) comprises a core wire (1311) and an insulation sheath (1312), the insulation sheath (1312) covers an outer side of the core wire (1311), the insulation sheath (1312) of each of the first conducting wires (1310) is provided with a notch (1313) exposing the core wire (1311) at an end portion (E1) close to the wiring plug (11), the current adjusting element (20) is disposed at the notch (1313) and connected to the core wire (1311).

3. The power cable (100) as described in claim 2, wherein the current adjusting element (20) comprises a plurality of first connecting portions (21) and at least one second connecting portion (22), the second connecting portion (22) connected between the two adjacent first connecting portions (21), the first connecting portion (21) is configured as a hollow cylindrical structure and is sleeved at the core wire (1311) exposed at the notch (1313), the second connecting portion (22) is configured as an arched structure or a planar structure.

4. The power cable (100) as described in claim 1, wherein the power cable (100) is a graphics card power wire, a motherboard power wire, a central processing unit power wire or a SATA interface power wire, the number of the first ribbon cables (131) is a plurality of, the number of the current adjusting elements (20) is at least one.

5. The power cable (100) as described in claim 1, wherein the power cable (100) is a graphics card power wire, the number of each of the first ribbon cables (131) and the current adjusting elements (20) is two, the two current adjusting elements (20) are insulated from each other.

6. The power cable (100) as described in claim 1, wherein the functional module (2) further comprises a protective housing (40), the insulating element (30) is disposed close to the wiring plug (11) and is spaced apart from the wiring plug (11), the protective housing (40) covers an outer side of the insulating element (30), the protective housing (40) is engaged with an end portion (E2) of the wiring plug (11) close to the power plug (12), the connecting harness (13) passes through an end portion (E3) of the protective housing (40) away from the wiring plug (11).

7. The power cable (100) as described in claim 6, wherein the functional module (2) further comprises a control circuit board (50), a temperature detector (60) and at least one display structure (70), the control circuit board (50) is conductively connected to the temperature detector (60), the at least one display structure (70) and the current adjusting element (20), the temperature detector (60) is adapted to detect a temperature of the current adjusting element (20), the control circuit board (50) is adapted to control the at least one display structure (70) to display a current temperature information of the current adjusting element (20) detected by the temperature detector (60), wherein the current temperature information comprises at least one of temperature value and temperature level.

8. The power cable (100) as described in claim 7, wherein a side wall of the insulating element (30) is provided with a conductive connecting hole (302), the functional module (2) further comprises a conductive connecting element (80), one end (E4) of the conductive connecting element (80) passes through the conductive connecting hole (302) and conductively connected to the current adjusting element (20), the other end (E5) of the conductive connecting element (80) is conductively connected to the control circuit board (50).

9. The power cable as described in claim 6, wherein the protective housing (40) comprises a first housing (41) and a second housing (42) cooperatively fixed with the first housing (41), the first housing (41) is provided with a first limiting groove (406), the second housing (42) is provided with a second limiting groove (407) oppositely disposed with the first limiting groove (406), in a thickness direction (Z) of the power cable (100), one end of the insulating element (30) is limited within the first limiting groove (406), the other end of the insulating element (30) is limited within the second limiting groove (407).

10. The power cable (100) as described in claim 6, the connecting harness (13) further comprises a second ribbon cable (135), the second ribbon cable (135) comprises a plurality of second conducting wires (1351), the second ribbon cable (135) is disposed between the insulating element (30) and the protective housing (40).
